Europäisches Patentamt

(19) European Patent Office

Office européen des brevets

(11) Publication number: **0 452 104 A2**

## EUROPEAN PATENT APPLICATION

(21) Application number: **91303142.3**

(22) Date of filing: **10.04.91**

(51) Int. Cl.⁵: **H01L 23/525, H01L 23/528**

(30) Priority: **11.04.90 JP 95924/90**

(43) Date of publication of application:
**16.10.91 Bulletin 91/42**

(84) Designated Contracting States:
**DE FR GB IT NL**

(71) Applicant: **KAWASAKI STEEL CORPORATION**
**1-28, 1-chome, Kitahonmachidori**
**Chuo-ku Kobe-shi Hyogo-651 (JP)**

(72) Inventor: **Kawana, Keiichi**
**1-5-11-510, Miyazaki**
**Chiba-shi, Chiba 280 (JP)**

(74) Representative: **Billington, Lawrence Emlyn et al**
**HASELTINE LAKE & CO Hazlitt House 28**
**Southampton Buildings Chancery Lane**
**London WC2A 1AT (GB)**

(54) **Programmable wiring.**

(57) A programmable wiring is provided for connecting wiring elements (12) in a channel region (11) with each other in a programmable manner, the programmable wiring (12) including programmable switches of the number less than the number of all combinations in the direction of connection in a switching matrix (14) for connecting the wiring elements (12) in accordance with a program. The number of programmable switches for connecting the respective wiring elements (12) with each other in a straight direction is less than the number of programmable switches for connecting the respective wiring elements (12) in a turn direction, a ratio of both numbers being preferably selected to be 0.2 : 1 to 0.5 : 1.

FIG.1

○ : PARALLEL CONNECTION

● : PERPENDICULAR CONNECTION

EP 0 452 104 A2

The present invention relates to programmable wiring for connecting wiring elements in a channel region in a semiconductor integrated circuit, for example, in a programmable manner.

Among many semiconductor devices there is known one in which wiring elements in a channel region are connected programmably to permit a user to construct a desired logic circuit. Such semiconductor devices sometimes include a switching matrix to connect the wiring elements with each other programmably.

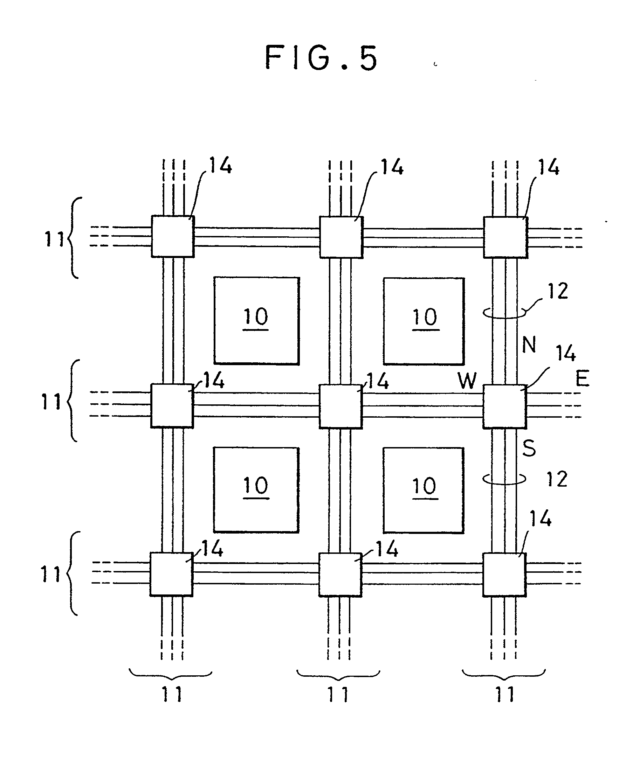

Fig. 5 exemplarily illustrates the construction of such a semiconductor device. As illustrated in Fig. 5, the semiconductor device includes a plurality of function modules 10, in each of which there are incorporated programmable logic circuits, etc. Wiring channel 11 regions are located each extending among the functional modules 10 and wiring elements 12 are laid on the wiring channel 11 longitudinally and laterally. Additionally, a switching matrix 14 is located at longitudinal and lateral intersections of the wiring elements 12.

The switching matrix 14 has a function to connect arbitrary wiring elements 12 in various directions (designated by symbols N, S, E and W in Fig. 5) by turning on and off a programmable switch in conformity with a program inputted externally, and forming a connection. Ideally, such provision of the programmable switches at intersections of all wirings in the switching matrix 14 can maximise the flexibility of the connections among between the wiring elements.

However, such a programmable switch would typically comprise a large area of static random access memory (SRAM) and thus cannot be provided at all wiring intersections.

Hence a limit is placed on the number of switches which may be installed. It is therefore necessary to install programmable switches in a switching matrix in accordance with such an upper limit. There is however a difficulty in that if the locations of those switches are to be arbitrarily determined, redundant wiring elements would result when those switches are programmably connected.

To solve the difficulty with the prior art, an embodiment of the present invention may provide programmable wiring in which programmable switches in a switching matrix may be provided such that wiring elements are connectable without any redundant or unuseable wiring element.

According to the present invention there is provided programmable wiring for connecting wiring elements in a channel region with each other in a programmable manner, in which programmable wiring there are provided programmable switches of a number less than the number of all combinations of connection directions in a switching matrix for programmably connecting the wiring elements with each other and the number of the programmable switches for connecting wiring elements in a parallel direction is less than the number of programmable switches for connecting wiring elements perpendicular to each other.

In the programmable wiring, provision of programmable switches in a switching matrix at all intersections among wiring elements assures free connection without limitation, ideally. However, an SRAM constituting a switching matrix takes up a considerable amount of space so that the number of programmable switches that may be installed is limited.

In this situation, the programmable switch may be considered to be of two types in terms of function, one for connection in a parallel direction (e.g., connection from the direction W wiring element 12 to the direction E wiring element 12 as illustrated in Fig. 5) and the other for connection of perpendicular elements (e.g., connection form the direction N wiring element 12 to the direction E wiring element 12). Provided programmable switches of varieties of such type are disposed without any limitation, concern may arise that unuseable or redundant wiring elements,are brought about upon programmable connection of the wiring elements.

Accordingly, the present inventor investigated at what rate the programmable switches of the above two types are useable for various semiconductor integrated circuits.

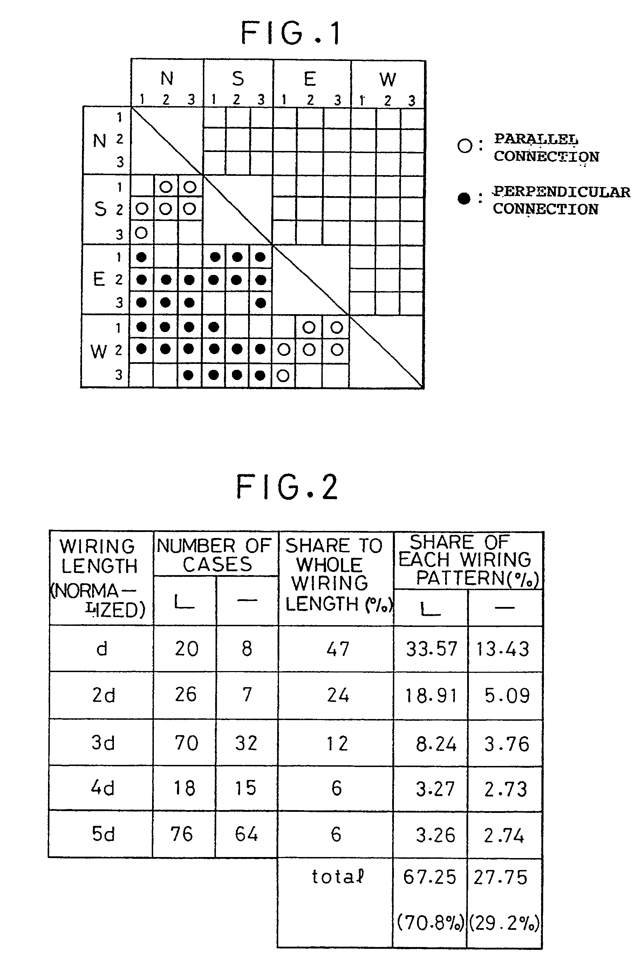

Fig. 2 illustrates results of the investigation. In Fig. 2, it is investigated how a wiring pattern connecting perpendicular wiring elements and a wiring pattern connecting those wiring elements in a parallel direction are employed on the semiconductor integrated circuit upon connecting wiring elements along length of wiring from d to 5d, with d taken to be the normalized wiring length.

More specifically, in the figure, there are illustrated the number of cases where the wiring patterns in the turn direction (indicated by a symbol "L") and in the straight direction (indicated by a symbol "-") are employed with the respective wiring lengths d to 5d, occupation rates (shares) of the respective wiring lengths d to 5d with respect to the whole wiring length, and a rate of occupation of the respective wiring patterns of the respective wiring lengths d to 5d with respect to the whole wiring length.

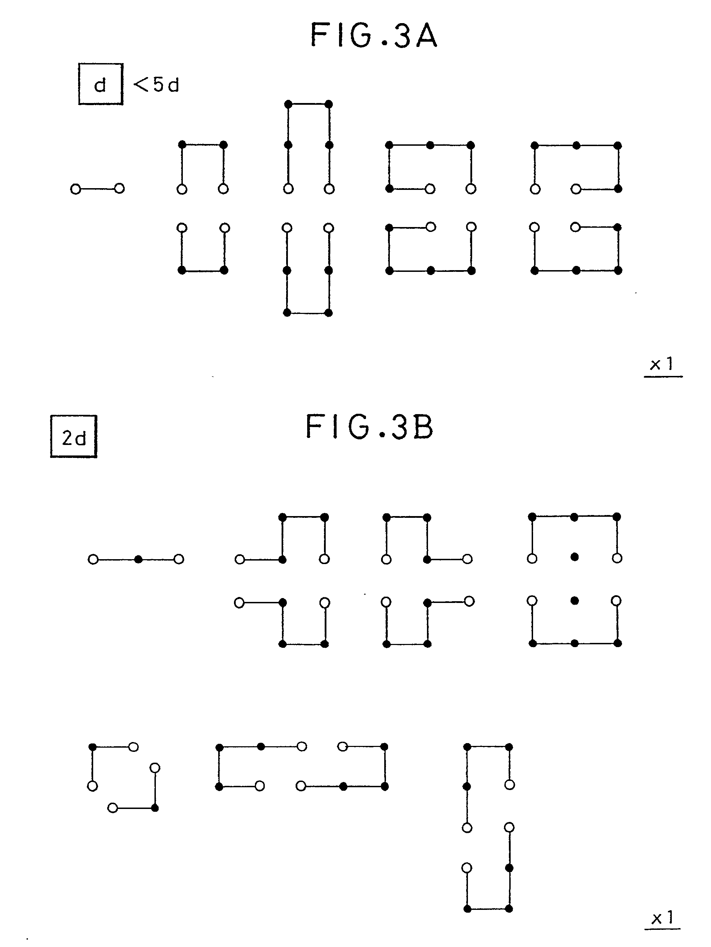

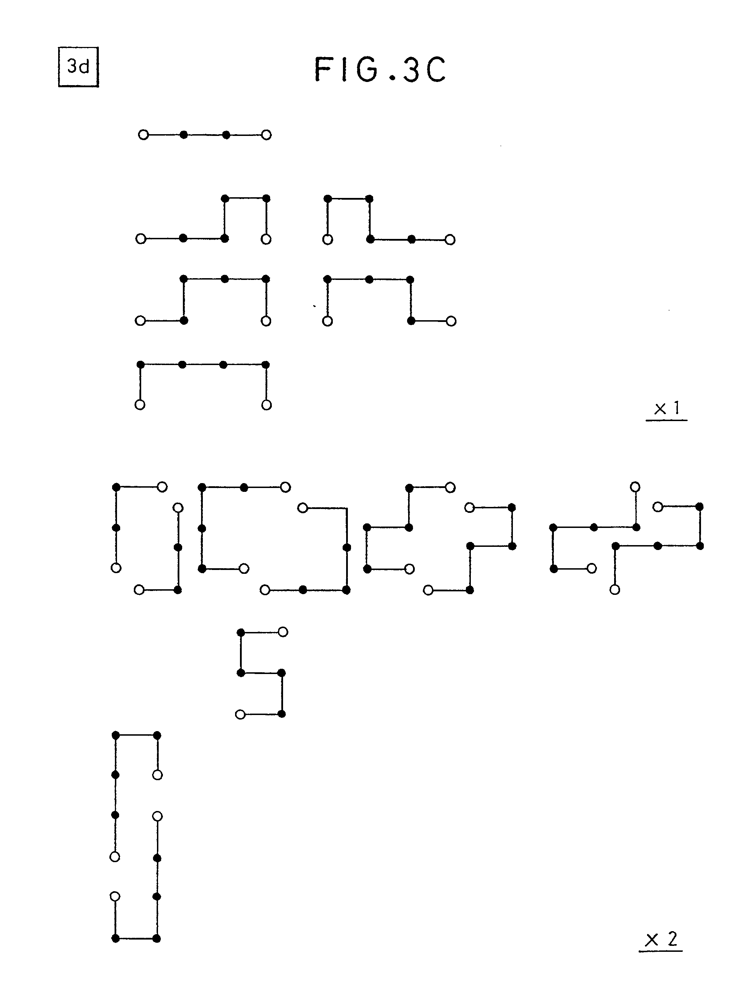

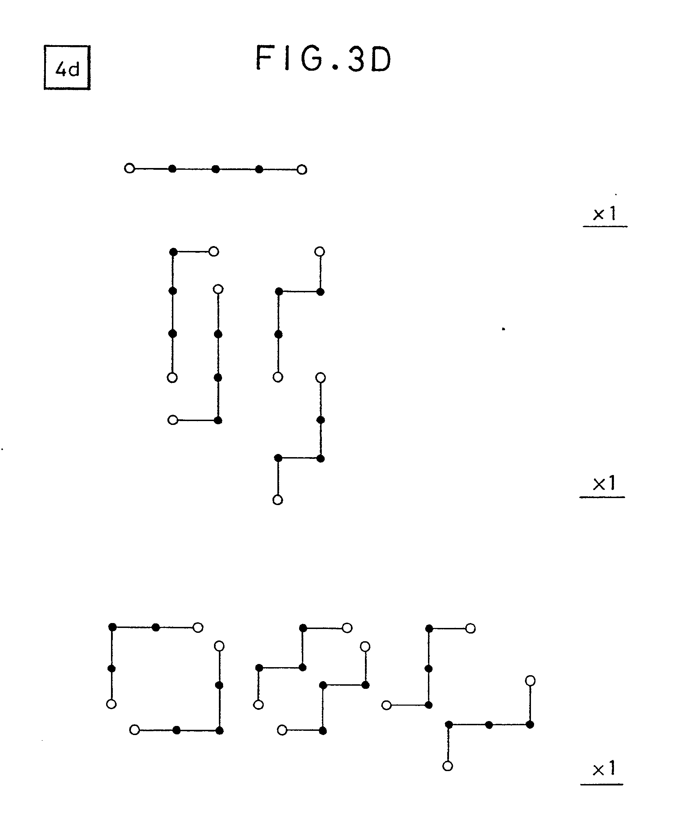

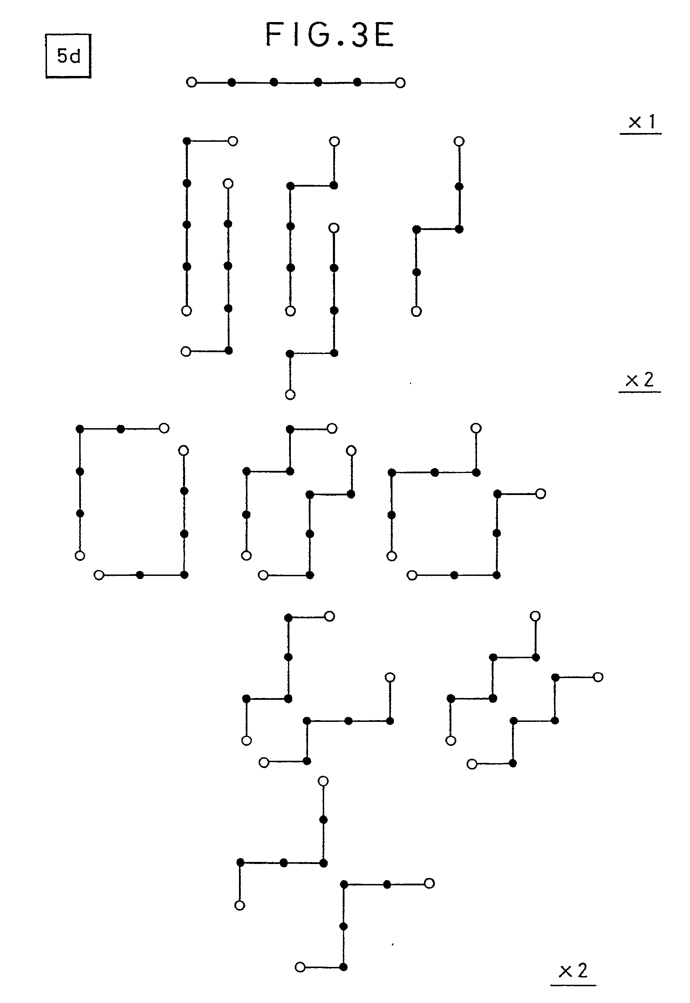

Further, Figs. 3A to 3E illustrate wiring connection patterns in the respective normalised wiring lengths d to 5d.

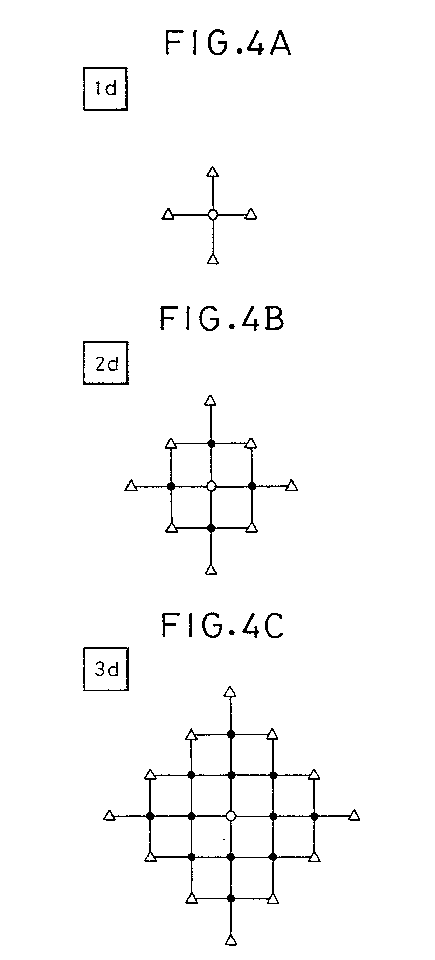

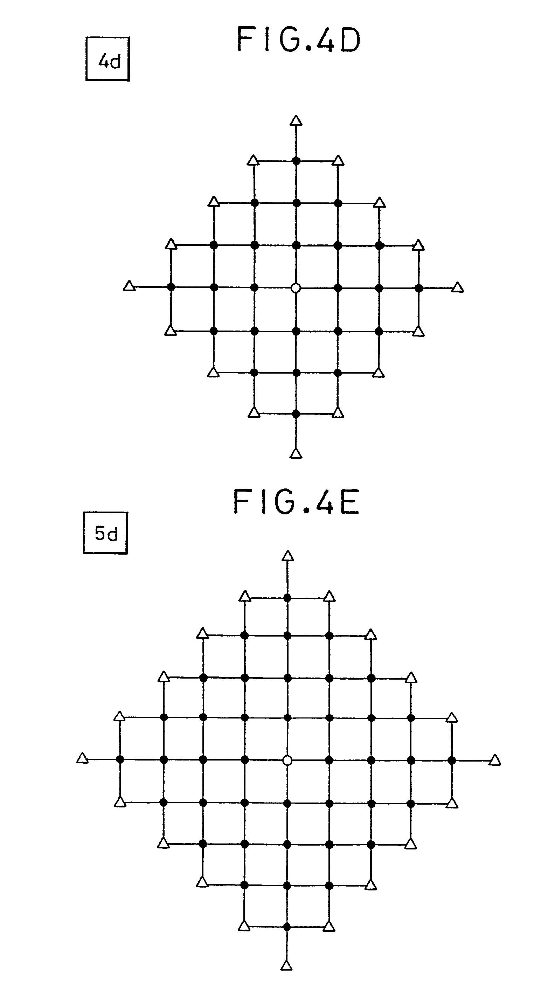

Additionally, Fig. 4 exemplarily illustrates connections extended to the normalised wiring length d to 5d from the center to the upper to lower and left to right portion.

Referring to the result of Fig. 2, a ratio of wiring length distributions, i.e., a wiring pattern for connection in the straight direction and a wiring pattern for perpendicular connection is 29.2 : 70.8, about 0.14 : 1.

From the consideration described above, provided for the programmable switches of the switching matrix, the number of programmable switches for connecting wiring elements in the parallel direction is made less than the number of programmable switches for connecting perpendicular wiring elements, with preferably the respective ratio lying between 0.2 : 1 and 0.5 : 1. Programmable switches capable of connection to various wirings can be provided.

In accordance with the present invention, upon connecting the wiring elements with each other using programmable switches, the occurence of any unuseable or redundant wiring element may safely be avoided. Accordingly, a switching matrix may be constructed with only the necessary programmable switches. This reduces the size of the switching matrix without losing the function of the programmable wiring.

The preferred embodiments will be described with reference to the drawings, wherein like elements have been denoted throughout the figures with like reference numerals, and wherein:

Fig. 1 is a diagram exemplarily illustrating the arrangement of programmable switches in a switching matrix associated with an embodiment of the present invention;

Fig. 2 is a diagram exemplarily illustrating the distribution patterns of programmable switches both straight and perpendicular with respect to wiring lengths, for description of the principle of the present invention;

Figs. 3A through 3E are views each illustrating examples of wiring patterns in each normalized wiring length;

Figs. 4A through 4E are views each illustrating the other examples of wiring patterns where wirings are extended to the normalized wiring lengths from the center to upper and lower, and left and right portions;

Fig. 5 is a plan view exemplarily illustrating a programmable wiring in a channel region wiring of a semiconductor integrated circuit.

In what follows, an embodiment of the present invention will be described in detail.

The embodiment is adapted by applying the present invention to a programmable switch provided in a switching matrix 14 for connecting wiring elements 1, 2 and 3, three wires respectively in directions N, S, E and W.

In the present embodiment, programmable switches are provided in a switching matrix 14 as schematically illustrated in Fig. 1. In Fig. 1, programmable switches for connecting wiring elements 12 with each other in a straight direction and in a turn direction in the programmable switch are indicated by "O" and " ●", respectively. Further, as illustrated in Fig. 1, the 12 programmable switches in the straight direction, and the 28 programmable perpendicular switches are provided. Accordingly, the ratio of the respective programmable switches is 12 : 28 = 0.43 : 1. Some programmable switches which may be connected to the peripheral wiring elements 1 or 3 are left out, and programmable switches are securely provided between the central wiring elements 2 - 2.

Hereby, there is eliminated the occurrence of any wiring element unuseable or redundant upon connecting wiring elements by programming.

Herein, although in the above embodiment the switching matrix of the programmable switch was exemplarily described as illustrated in Fig. 1, .a programmable switch upon practising the present invention is not limited to that illustrated in the figure. Essentially, provided the ratio of programmable switches for connecting parallel and perpendicular wiring elements ranges between 0.2 : 1 and 0.5 : 1, a switch may be provided in a proper arrangement in accordance with the invention.

## Claims

1. A programmable wiring for connecting wiring elements (12) in a channel region (11) with each other in a programmable manner characterized in that programmable switches less than the number of all combinations in the direction of connections are provided in a switching matrix (14) for connecting the wiring elements (12) with each other, and that the number of programmable switches for connecting the wiring elements (12) in a parallel direction is less than the number of programmable switches for connecting wiring elements (12) perpendicular to each other.

2. A programmable wiring according to claim 1 wherein the number of said programmable switches for parallel connection and the number of said programmable switches for perpendicular connection range in their ratio from 0. 2 : 1 to 0. 5 : 1.

3. A programmable wiring according to claims 1 or 2 wherein some of the programmable switches connected to peripheral wiring elements (12) are left out, and programmable switches are securely provided among central wiring elements (12).

4. A programmable wiring according to claims 1, 2 or 3 wherein said programmable switch includes a static random access memory.

## FIG.1

| | | N 1 | N 2 | N 3 | S 1 | S 2 | S 3 | E 1 | E 2 | E 3 | W 1 | W 2 | W 3 |
|---|---|---|---|---|---|---|---|---|---|---|---|---|---|
| N | 1 | | | | | | | | | | | | |
| N | 2 | | | | | | | | | | | | |
| N | 3 | | | | | | | | | | | | |
| S | 1 | | ○ | ○ | | | | | | | | | |
| S | 2 | ○ | ○ | ○ | | | | | | | | | |
| S | 3 | ○ | | | | | | | | | | | |
| E | 1 | ● | | | ● | ● | ● | | | | | | |
| E | 2 | ● | ● | ● | ● | ● | ● | | | | | | |
| E | 3 | ● | ● | ● | | | ● | | | | | | |
| W | 1 | ● | ● | ● | ● | | | | ○ | ○ | | | |
| W | 2 | ● | ● | ● | ● | ● | ● | ○ | ○ | ○ | | | |
| W | 3 | | | ● | ● | ● | ● | ○ | | | | | |

○: PARALLEL CONNECTION

●: PERPENDICULAR CONNECTION

## FIG.2

| WIRING LENGTH (NORMA-LIZED) | NUMBER OF CASES | | SHARE TO WHOLE WIRING LENGTH (%) | SHARE OF EACH WIRING PATTERN(%) | |
|---|---|---|---|---|---|
| | ∟ | — | | ∟ | — |
| d | 20 | 8 | 47 | 33.57 | 13.43 |
| 2d | 26 | 7 | 24 | 18.91 | 5.09 |
| 3d | 70 | 32 | 12 | 8.24 | 3.76 |
| 4d | 18 | 15 | 6 | 3.27 | 2.73 |
| 5d | 76 | 64 | 6 | 3.26 | 2.74 |
| | | | total | 67.25 (70.8%) | 27.75 (29.2%) |

# FIG.3A

$\boxed{d}$ $<5d$

$\underline{\times 1}$

# FIG.3B

$\boxed{2d}$

$\underline{\times 1}$

3d

# FIG.3C

×1

×2

# FIG.3D

4d

×1

×1

×1

# FIG.3E

5d

×1

×2

×2

# FIG.4A

1d

# FIG.4B

2d

# FIG.4C

3d

# FIG.4D

4d

# FIG.4E

5d

# FIG.5